(19)

**Europäisches Patentamt**
**European Patent Office**
**Office européen des brevets**

(11) **EP 1 405 370 B1**

(12) **EUROPÄISCHE PATENTSCHRIFT**

(45) Veröffentlichungstag und Bekanntmachung des Hinweises auf die Patenterteilung:
**07.03.2007 Patentblatt 2007/10**

(21) Anmeldenummer: **02740385.6**

(22) Anmeldetag: **28.05.2002**

(51) Int Cl.:
*H01Q 21/30* (2006.01)          *H01Q 5/00* (2006.01)
*H01P 1/213* (2006.01)

(86) Internationale Anmeldenummer:
**PCT/DE2002/001955**

(87) Internationale Veröffentlichungsnummer:
**WO 2003/005488 (16.01.2003 Gazette 2003/03)**

(54) **ANTENNENANSCHLUSSANORDNUNG, ANTENNENSIGNALSPLITTER UND VERFAHREN ZUR EMPFANGSFREQUENZSTEUERUNG**

ANTENNA CONNECTOR ARRANGEMENT, ANTENNA SIGNAL SPLITTER AND METHOD FOR RECEIVER FREQUENCY CONTROL

ENSEMBLE DE RACCORDEMENT D'ANTENNE, SEPARATEUR DE SIGNAUX D'ANTENNE ET PROCEDE POUR REGULER UNE FREQUENCE DE RECEPTION

(84) Benannte Vertragsstaaten:
**DE FR GB**

(30) Priorität: **29.06.2001 DE 10131457**

(43) Veröffentlichungstag der Anmeldung:
**07.04.2004 Patentblatt 2004/15**

(73) Patentinhaber: **ROBERT BOSCH GMBH**
**70442 Stuttgart (DE)**

(72) Erfinder:
  • **KOTTSCHLAG, Gerhard**
    **31139 Hildesheim (DE)**
  • **POCHOWSKI, Lutz**
    **31141 Hildesheim (DE)**

  • **PITZ, Gerhard**
    **31139 Hildesheim (DE)**

(56) Entgegenhaltungen:
EP-A- 0 567 766          EP-A- 0 910 132
EP-A- 1 150 376          WO-A-01/95507
WO-A-99/65743          GB-A- 613 927
US-A- 3 703 685

  • **MALEVICH I Y: "A LOW-LOSS SPLITTER" TELECOMMUNICATIONS AND RADIO ENGINEERING, BEGELL HOUSE, INC., NEW YORK, NY, US, Bd. 48, Nr. 4, 1. April 1993 (1993-04-01), Seiten 30-31, XP000476147 ISSN: 0040-2508**

**Beschreibung**

Die Erfindung geht von einer Anordnung zum Anschluss mindestens zweier Empfänger an eine gemeinsame Antenne und von einem Verfahren zur Steuerung der Empfangsfrequenzen mindestens zweier an eine gemeinsame Empfangsantenne angeschlossener Empfänger aus.

Sollen in einem Funkempfänger, insbesondere einem Rundfunkempfänger, mehrere Signale gleichzeitig ausgewertet werden, z. B. Rundfunksignale eines eine Musiksendung ausstrahlenden Rundfunksenders und weitere Rundfunksignale eines weiteren, beispielsweise digital codierte Verkehrsfunkinformationen ausstrahlenden Senders, so wird das von einer Empfangsantenne empfangene Rundfunkfrequenzgemisch, in dem auch die Rundfunkfrequenzen der interessierenden Sender enthalten sind, von einem Antennensignalsplitter auf die verschiedenen, auf die Rundfunkfrequenzen der interessierenden Sender abgestimmten Empfänger aufgeteilt.

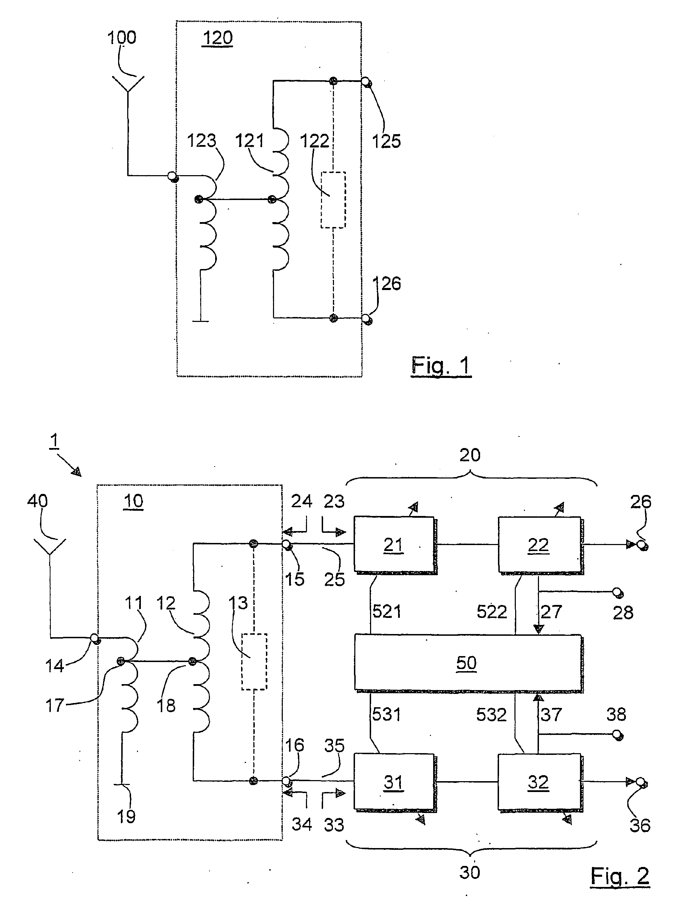

Oftmals wird hierzu ein Antennensignalsplitter 120 gemäss Figur 1 verwendet, der aus einem Transformator 121 mit mehreren Windungen und Mittelanzapfung zur Zuführung des Antennensignals der Empfangsantenne 100 sowie Anschlüssen 125, 126 zur Auskopplung des gesplitteten Antennensignals durch die angeschlossenen Empfänger und darüber hinaus die Ausgangsanschlüsse 125, 126 überbrückenden Widerständen 122 besteht. Durch geeignete Wahl des Widerstandswerts des bzw. der Widerstände 122, nämlich beispielsweise bei einem Splitter mit zwei Ausgängen idealerweise dem doppelten der Eingangsimpedanz der an die Ausgangsanschlüsse 125, 126 des Splitters 120 angeschlossenen Empfängerzüge, die idealerweise der Impedanz der Antennensignalleitung entspricht, wird eine bidirektionale Anpassung der Antennensignalspltterausgänge 125 und 126 an die Impedanz des Systems oder des jeweiligen Empfängers erreicht. Ein zusätzlicher Eingangstransformator 123 paßt die Impedanz der Antenne 100 bzw. der Antennenzuleitung an die Eingangsimpedanz des splittenden Transformators 121 an.

Diese Schaltung ist breitbandig verwendbar und unempfindlich gegenüber Fehlanpassung an einzelnen Antennsignalsplitterausgängen 125, 126. Nachteilig ist die im gesamten nutzbaren Frequenzbereich wirkende Dämpfung, die aufgrund der breitbandigen Signalaufieilung zwangsläufig entsteht.

Aus GB-A-613 927 ist eine Empfängeranordnung mit mindestens zwei Empfängern bekannt, wobei die mindestens zwei Empfänger über Antennensignalleitungen an eine gemeinsame Antenne angeschlossen sind, wobei jeder der Empfänger über ein festes Vorfilter mit Bandpasscharakteristik verfügt, so dass sie nur im Bereich ihrer in unterschiedlichen Frequenzbereichen liegenden Durchlassbereiche eine Impedanzanpassung an die ihnen zugeführten Antennensignalleitungen aufweisen. Jeder der Empfänger ist hierbei auf eine bestimmte Arbeitsfrequenz oder einen bestimmten schmalen Arbeitsfrequenzbereich beschränkt, in dem ihm infolge der schmalen Bandbreiten der Vorfilter eine maximale Antennensignalleistung zur Verfügung steht, während außerhalb des Arbeitsfrequenzbereichs infolge der schmalen Bandbreiten der Vorfilter praktisch eine vollständige Reflexion des Antennensignals vorliegt. Damit wird erreicht, dass jedem der Empfänger in dem von ihm ausgewertet Frequenzbereich das Antennensignal näherungsweise verlustfrei zur Verfügung steht.

Vorteile der Erfindung

Die erfindungsgemäße Anordnung mit mindestens zwei an eine gemeinsame Antenne angeschlossenen Empfängern mit den Merkmalen des ersten unabhängigen Patentanspruchs hat den Vorteil, dass den einzelnen angeschlossenen Empfängern, sofern diese auf unterschiedliche Empfangsfrequenzen abgestimmt sind, jeweils näherungsweise die gesamte Empfangsenergie der jeweiligen Empfangsfrequenz zur Verfügung steht.

Dies wird erfindungsgemäß dadurch erreicht, dass die Eingangsimpedanzen der mindestens zwei Empfänger nur schmalbandig im Bereich ihrer aktuellen Empfangsfrequenzen an die Impedanzen der ihnen zugeführten Antennsignalleitungen angepaßt sind. Darüber hinaus sind die Antennensignalleitungen untereinander hochohmig verbunden, wobei die hochohmige Verbindung im Idealfall einen unendlichen oder einen gegen unendlich gehenden Widerstand aufweist, so daß dieser auch entfallen kann.

Eine derartige Ausbildung der Erfindung bewirkt, dass jeder Empfänger nur für seine jeweilige Empfangsfrequenz und eng benachbarte Frequenzen eine Eingangsimpedanz aufweist, die der Splitter-Ausgangsimpedana bzw, der Impedanz der Antennensignalzuleitungen entspricht und infolge der damit erreichten Impedanzanpassung für eine Signalweiterleitung vom Splitter zu den Empfängern optimiert ist. Für alle anderen Frequenzen, die mit den Empfangsfrequenzen der Empfänger bzw. diesen eng benachbarten Frequenzen nicht übereinstimmen, weicht die jeweilige Eingangsimpedanz der Empfänger stark von der Splitter-Ausgangsimpedanz ab, was eine Signalreflexion an den Eingängen der Empfänger zur Folge hat.

Bei Antennensignalsplittern gemäss dem Stand der Technik wird die an den Eingängen der Empfänger reflektierte Energie in den Abschlußwiderständen 122 absorbiert.

Sind hingegen der oder die Abschlußwiderstände 122 hochohmig ausgebildet, oder entfallen ganz, werden die an den Empfängern reflektierten Signalanteile in den Splittertransformator zurückgeführt und erreichen somit die jeweils anderen Splitterausgänge. Sofern die an die Splitterausgänge angeschlossenen Empfänger auf unterschiedliche Empfangsfrequenzen abgestimmt sind, erhält somit jeder der angeschlossenen Empfänger fast die gesamte Empfangsenergie der jeweiligen Frequenz, auf die er abgestimmt ist, da die reflektierten Signale der anderen Ausgänge nur in einem impedanzangepaßten Empfänger aufgenommen und aus dem System ausgekoppelt werden können. Die erfindungsgemäße Anordnung ermöglichen somit eine geringere Signaldämpfung bei einer interessierenden Funkfrequenz durch die Signalaufteilung mittels des Antennensignalsplitters.

Das erfindungsgemäße Verfahren zur Steuerung mindestens zweier an eine gemeinsame Empfangsantenne angeschlossener Empfänger mit den Merkmalen des unabhängigen Verfahrensanspruchs ermöglicht eine stets optimale Signalaufteilung der Antennensignale auf die einzelnen Empfänger derart, dass jeder Empfänger das Antennensignal im Bereich seiner aktuellen Empfangsfrequenz mit geringstmöglicher Signaldämpfung erhält. Idealerweise erhält jeder Empfänger das Antennensignal im Bereich seiner Empfangsfrequenz ungedämpft.

Dies wird erfindungsgemäß dadurch erreicht, dass die Empfangsfrequenzen der mindestens zwei Empfänger so eingestellt werden, dass sie zueinander einen vorgegebenen Mindestfrequenzabstand einhalten. Der Mindestfrequenzabstand ist dabei durch die Bandbreite vorgegeben, innerhalb derer die Empfänger eine Eingangsimpedanzanpassung an die ihnen zugeführten Antennensignalleitungen aufweisen.

Dem beanspruchten Steuerungsverfahren liegt die eingangs erwähnte Erkenntnis zugrunde, dass an einem jeweiligen Empfänger nur dann eine maximale Empfangssignalleistung für die betrachtete Frequenz vorliegt, wenn die beiden Empfängerzüge auf voneinander verschiedene Empfangsfrequenzen abgestimmt sind, so dass das Antennensignal für eine jeweils betrachtete Empfangsfrequenz nur von einem der Empfänger aus dem System ausgekoppelt, von den übrigen Empfängern hingegen reflektiert wird. Dies ist nur dann zu verwirklichen, wenn betreffend einer bestimmten interessierenden Empfangsfrequenz nur ein einziger Empfänger eine Eingangsimpedanzanpassung, die übrigen Empfänger hingegen einer Eingangsimpedanzfehlanpassung aufweisen.

Eine Weiterbildung des erfindungsgemäßen Verfahrens richtet sich darauf, dass bei Verschlechterung der Empfangsqualität einer mittels eines ersten der mindestens zwei Empfänger empfangenen Funkfrequenz unter einen vorgegebenen Wert und für den Fall, dass die weitere Empfangsfrequenz des mindestens einen weiteren Empfängers einen vorgegebenen Mindestfrequenzabstand zu der Empfangsfrequenz des ersten Empfängers nicht aufweist, die weitere Empfangsfrequenz des mindestens einen weiteren Empfängers so eingestellt wird, dass sie zur Empfangsfrequenz des ersten Empfängers einen vorgegebenen Mindestfrequenzabstand einhält.

Demgemäß ist es durchaus zulässig, an mehreren Empfängern des Mehrempfängersystems dieselbe Empfangsfrequenz einzustellen und somit eine Auskopplung des Antennensignals für die gleiche Empfangsfrequenz mittels mehrerer Empfänger aus dem System und die damit verbundene Signaldämpfung zuzulassen, solange die empfangene Rundfunkfrequenz mit ausreichender Empfangsqualität empfangen werden kann. Liegt bzw. verschlechtert sich die Empfangsqualität der an mehreren Empfängern gleichermaßen eingestellten Rundfunkfrequenz unter einen vorgegebenen Wert, kann eine Qualitätsverbesserung möglicherweise dadurch erzielt werden, dass die Empfangssignalleistung für die betrachtete Rundfunkfrequenz erhöht wird. Dies wird bei dem beschriebenen Verfahren dadurch erreicht, dass nur einer der Empfänger auf die betrachtete Rundfunkfrequenz abgestimmt bleibt, während der oder die übrigen Empfänger auf andere Frequenzen abgestimmt werden, so dass diese bezüglich der ursprünglich betrachteten Frequenz eine Eingangsimpedanzfehlanpassung aufweisen. Dann steht dem ersten Empfänger, der auf die betrachtete Rundfunkfrequenz eingestellt bleibt, die gesamte Empfangssignalenergie bei der betrachteten Frequenz zur Verfügung.

Zeichnungen

Ausführungsbeispiele der Erfindung sind in den Zeichnungen dargestellt und werden nachfolgend näher erläutert.

Es zeigen

Figur 1 zeigt ein Blockschaltbild eines Antennensignalsplitters gemäß dem beschriebenen Stand der Technik,

Figur 2 ein Blockschaltbild einer erfindungsgemäßen Anordnung zur Verwendung in einem mobilen Rundfunkempfänger, insbesondere einem Autoradio,

Figur 3 den Verlauf der Signalreflexionen infolge Fehlanpassung über der Rundfunkfrequenz.

Beschreibung der Ausführungsbeispiele

Die Erfindung eignet sich in besonderer Weise zum Einsatz in einem mobilen Rundfunkempfänger, beispielsweise einem Autoradiogerät, das zum Empfang von frequenzmodulierten Ultra-Kurz-Wellen- (UKW-) Rundfunksignalen ausgebildet ist. Die Erfindung wird daher nachfolgend am Beispiel eines Autoradios ohne Beschränkung der Allgemeinheit und ohne Ausschluß weiterer möglicher Anwendungsfälle, wie beispielsweise für anderweitige Funk- oder Rundfunkempfänger, Funkgeräte oder ähnliches beschrieben.

Das an einer Empfangsantenne 40 der Anordnung gemäß Figur 2 anstehende Rundfunkfrequenzgemisch, das aus einer Überlagerung der am Empfängerstandort empfangbaren Rundfunkfrequenzen besteht - in der Regel sind in dicht besiedelten Gebieten, wie in Europa, aufgrund der vorhandenen Senderlandschaft an nahezu jedem Empfängerstandort eine Mehrzahl von Rundfunkfrequenzen empfangbar - ist einem Eingang 14 eines Antennensignalsplitters 10 zugeführt. Dieser weist einen Transformator 12 mit einer Mehrzahl von Windungen auf. Das Antennensignal ist einer Mittelanzapfung 18 des Transformators 12 zugeführt. Ein zusätzlicher Eingangstransformator 11 ist zur Anpassung der Impedanz der Antenne 40 bzw. der Antennenzuleitung an die Eingangsimpedanz des splittenden Transformators 12 vorgesehen. Von einem Abgriff 17 des Eingangstransformators 11, der einseitig mit der Antenne 40 und mit seinem entgegengesetzten Anschluß mit einem Bezugspotential 19 verbunden ist, wird das impedanzangepasste Antennensignal dem Mittelabgriff 18 des splittenden Transformators 12 zugeführt. Die jeweiligen Endanschlüsse des splittenden Transformators 12 bilden einen ersten Signalausgang 15 des Antennensignalsplitters 10 und mindestens einen zweiten Signalausgang 16 des Splitters 10. Der Splitter 10 umfaßt weiterhin einen hochohmig ausgeführten ohmschen elektrischen Widerstand 13, der die Signalausgänge 15 und 16 des Antennensignalsplitters 10 miteinander verbindet. Der Wert des ohmschen Widerstands 13 liegt mindestens um eine Größenordnung über der Antennenimpedanz bzw. der Ausgangsimpedanz der Signalausgänge 15 und 16 des Antennensignalsplitters 10. Der Wert des ohmschen Widerstands 13 kann sogar soweit erhöht werden, dass dieser vollständig entfallen kann.

Beim in Figur 2 dargestellten Ausführungsbeispiel der Erfindung verfügt der Splitter 10 über zwei Signalausgänge 15 und 16. An den ersten Signalausgang 15 des Splitters 10 ist über eine erste Antennensignalzuleitung 25 das gesplittete Antennensignal einem ersten Empfänger 20 zugeführt.

Der erste Empfänger 20 umfaßt ein erstes steuerbares Vorfilter 21, das eine schmalbandige Impedanzanpassung der Eingangsimpedanz 23 des ersten Empfängers 20 an die Leitungsimpedanz 24 der ersten Antennensignalzuleitung 25 ermöglicht. Der erste Empfänger 20 umfaßt weiter ein erstes Empfangsteil 22, dem das durch den ersten Vorkreis 21 vorgefilterte Antennensignal zugeführt ist. Im ersten Empfangsteil 22 wird das Antennensignal durch Mischung mit einer geeignet gewählten ersten Mischfrequenz in eine Zwischenfrequenzebene, im Falle des betrachteten UKW-FM-Rundfunkempfängers beispielsweise bei 10,7 MHz - abweichende Zwischenfrequenzen, beispielsweise 24,9375 MHz, können je nach Anwendungsfall ebenfalls sinnvoll sein - herabgemischt. Die Mischfrequenz zur Herabmischung des eingehenden Antennensignals in die Zwischenfrequenzebene wird nach Maßgabe eines von einer Steuerung 50 zur Verfügung gestellten ersten Abstimmsteuersignals 522 bestimmt. Die Abstimmung des ersten Empfängers 20 auf eine bestimmte Empfangsfrequenz erfolgt somit durch entsprechende Wahl der Mischfrequenz nach Maßgabe eines entsprechenden ersten Abstimmsteuersignals 522.

Am Ausgang des ersten Empfangsteils 22 steht das zwischenfrequente Signal an einem Ausgang 26 zur hier nicht weiter interessierenden Weiterverarbeitung zur Verfügung. An einem weiteren Ausgang des ersten Empfangsteils 22 ist ein die Empfangsqualität des empfangenen Rundfunksignals bzw. der empfangenen Rundfunkfrequenz anzeigendes erstes Qualitätssignal 27 abnehmbar. Dieses kann beispielsweise die Empfangssignalfeldstärke der empfangenen Rundfunkfrequenz anzeigen. Darüber hinaus kann vorgesehen sein, dass mittels der Signalweiterverarbeitung 26 weitere, die Empfangsqualität der empfangenen Rundfunkfrequenz anzeigende Qualitätshilfssignale abgeleitet werden, die in das Qualitätssignal 27 einfließen können. Diese weiteren Qualitätshilfssignale sind in der Figur durch die Quelle 28 symbolisiert.

Die Steuerung 50 erzeugt neben dem ersten Abstimmsteuersignal 522 ein Vorfiltersteuersignal 521 zur Steuerung des ersten Vorfilters 21 dergestalt, dass eine ideale Impedanzanpassung der schmalbandigen Eingangsimpedanz 23 des ersten Vorfilters 21 an die Antennensignalzuleitungsimpedanz 24 jeweils im Bereich der mittels des Abstimmsteuersignals 522 eingestellten Empfangsfrequenz vorliegt.

An den zweiten Signalausgang 16 des Splitters 10 ist über eine zweite Antennensignalzuleitung 35 ein zweiter Empfänger 30 angeschlossen, der ein zweites steuerbares Vorfilter 31, das nach Maßgabe eines zweiten Vorfiltersteuersignals 531 gesteuert wird und ein zweites Empfangsteil 32, das nach Maßgabe eines zweiten Abstimmsteuersignals 532 von der Steuerung 50 gesteuert wird, umfasst. Das am Ausgang des zweiten Empfangsteils 33 abnehmbare Zwischenfrequenzsignal ist an einem zweiten Ausgang 36 abnehmbar und wird auch hier einer weiteren Verarbeitung zugeführt. Vergleichbar dem ersten Empfängerzug liefert auch das zweite Empfangsteil 32 ein die Empfangsqualität der empfangenen Rundfunkfrequenz anzeigendes zweites Qualitätssignal 37 an die Steuerung 50, das um Informationen aus der Weiterverarbeitung, hier repräsentiert durch die Quelle 38, ergänzt sein kann.

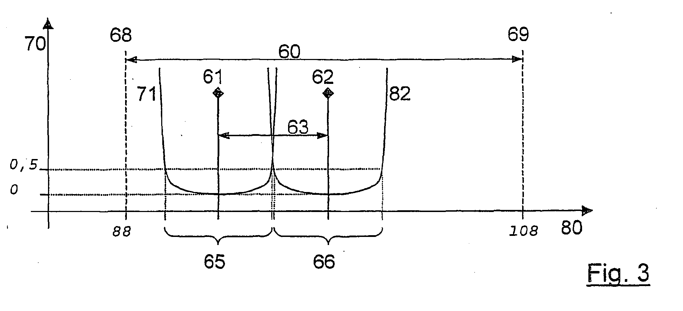

In Figur 3 sind die Verläufe 71, 82 der Impedanzanpassung der Vorfilter 21 und 31 in Abhängigkeit der jeweils eingestellten Empfangsfrequenz 61 bzw. 62 eines jeden Empfängers 20, 30 über der Empfangsfrequenz 80 dargestellt.

Die Bandbreiten 65 und 66 der Vorfilter 21 und 31, stellen die Abschnitte der in den Kurven 71 und 82 dargestellten Frequenzverläufe dar, innerhalb derer eine Impedanzanpassung der Vorfiltereingangsimpedanzen 23 und 33 und damit der Empfängereingangsimpedanzen erfolgt. Diese sind in der Figur durch die 3dB-Grenzfrequenzen gegeben.

Da Ziel vorliegender Erfindung ist, eine Antennensignalsplittung mit möglichst geringer Dämpfung für beide der mindestens zwei angeschlossenen Empfänger zu erreichen, kann die zur Charakterisierung von Filtern üblicherweise angewandte 3dB-Grenzfrequenz schon als mit einer zu starken Signaldämpfung einhergehend angesehen werden. Für diesen Fall empfiehlt sich die Definition einer abweichenden Grenzfrequenz, z. B. einer 1dB-Grenzfrequenz und einer entsprechenden 1dB-Bandbreite, innerhalb derer eine Impedanzanpassung vorliegt.

Die 3dB-Bandbreiten der Kurven 71 und 81 gemäß Figur 3 ergeben sich beim vorliegenden Ausführungsbeispiel zu jeweils ungefähr 5 MHz. Wird eine 1dB-Bandbreite festgelegt, fällt diese entsprechend schmaler aus

Wird beispielsweise am ersten Empfangsteil 22 mittels des ersten Abstimmsteuersignals 522 eine erste Empfangsfrequenz 61 eingestellt, wird das erste Vorfilter 21 mittels des ersten Vorfiltersteuersignals 521 derart nachgeführt, dass die Eingangsimpedanz 23 des ersten Vorfilters 21 respektive Empfängers 20 im Sinne einer Impedanzanpassung bestmöglich an die Impedanz 24 der ihm zugeführten Antennensignalzuleitung 25 angepaßt wird. Dies bedeutet, dass die Kurve 71 in Figur 3 in Abhängigkeit einer am ersten Empfangsteil 22 eingestellten Empfangsfrequenz 61 dieser Empfangsfrequenz nachgeführt wird, so daß die Empfangsfrequenz 61 in der Darstellung stets in der Mitte der Kurve 71, also bei einem Dämpfungsminimum zu liegen kommt. Das bedeutet, dass für die jeweils eingestellte Empfangsfrequenz 61 zu jedem Zeitpunkt eine ideale Impedanzpassung der Eingangsimpedanz 23 des Vorfilters 21 vorliegt, so dass für die eingestellte Empfangsfrequenz 61 ein Maximum an Antennensignalleistung aus dem Splitter 10 ausgekoppelt werden kann.

Wie Figur 3 zu entnehmen, erfolgt auch für den zweiten Empfänger 30 durch geeignete Steuerung des zweiten Vorfilters 31 in analoger Weise eine Impedanzanpassung der Eingangsimpedanz 33 des zweiten Vorfilters 31 an die Impedanz 34 der Antennensignalzuleitung 35 in Abhängigkeit der am zweiten Empfangsteil 32 eingestellten zweiten Empfangsfrequenz 62. Die Reflexion des am zweiten Signalausgang des Splitters 16 anstehenden Antennensignals am zweiten Vorfilter 31 ist in Figur 3 an Kurve 82 ablesbar, ebenso wie an der korrespondierende Kurve 71 für das am ersten Ausgang 15 des Antennensignalsplitters 10 anstehende Antennensignal.

Im Falle eines zum Betrieb im europäischen Raum vorgesehenen FM-UKW-Rundfunkempfängers liegt das interessierende Rundfunkfrequenzband 60 zwischen einer unteren Bandgrenze 68 von 87,5 MHz und einer oberen Bandgrenze 69 bei 108,0 MHz. Um die eingangs beschriebene Wirkung einer maximalen Signalauskopplung einer jeweils interessierenden Rundfunkfrequenz aus dem Antennensignalsplitter 10 zu ermöglichen, ist es erforderlich, dass für die beiden interessierenden Frequenzen 61 und 62 jeweils nur einer der beiden Empfänger 20 und 30 eine Eingangsimpedanzanpassung aufweist, während jeder der beiden Empfänger 20 und 30 für die jeweils andere der beiden Frequenzen 61 und 62 eine Eingangsimpedanzfehlanpassung aufweisen muss. Dies kann dadurch erreicht werden, dass die mindestens zwei Empfänger 20, 30 der Vorrichtung 1 auf unterschiedliche Empfangsfrequenzen 61 und 62 abgestimmt werden, die einen Mindesfrequenzabstand 63 zueinander aufweisen, der sich aus der Bandbreite, innerhalb der die Vorstufen 21 und 31 eine Eingangsimpedanzanpassung aufweisen, ergibt. Die Bandbreite 65 und 66 des ersten und zweiten Vorfilters 21 und 31 ist bei dem in Figur 3 dargestellten Ausführungsbeispiel als jeweils der Frequenzbereich definiert, innerhalb dessen das Maß der Reflexion eines Antennensignals an der jeweiligen Vorstufe unter einem festgelegten Faktor, in dem Beispiel der Figur 1/2 (entspricht 3dB) liegt. Somit müssen erfindungsgemäß die beiden Empfangsfrequenzen 61 und 62, die an dem ersten Empfangsteil 22 und dem zweiten Empfangsteil 32 eingestellt sind, zueinander um den Mindestfrequenzabstand

$$\Delta f_{min} = \frac{1}{2} \times \left( B_1 + B_2 \right),$$

wobei $B_1$: Bandbreite 65 des ersten Vorfilters 21,
$B_2$: Bandbreite 66 des zweiten Vorfilters 31,

im Fall der ersten Bandbreite 65 gleich der zweiten Bandbreite 66 um die Bandbreite 65 bzw. 66 der Vorfilter 21 bzw. 31, beabstandet sein. Die Bandbreite 65 bzw. 66 des ersten und des zweiten Vorfilters kann dabei, wie in der Figur dargestellt, durch die 3dB-Grenzfrequenzen, alternativ dazu aber auch vorzugsweise durch abweichende Grenzfrequenzen, bei denen eine geringere Signaldämpfung vorliegt, definiert sein.

Gemäss einer vorteilhaften Weiterbildung kann es darüber hinaus vorgesehen sein, dass auch enger zueinander benachbarte Rundfunkfrequenzen 61 und 62 und gegebenenfalls weitere Frequenzen zugelassen werden, solange diese mittels der entsprechend zugeordneten Empfangsteile mit ausreichender Empfangsqualität empfangen werden können. Wird hingegen mindestens einer der interessierenden Empfangsfrequenzen mit nicht oder nicht mehr ausreichender Empfangsqualität empfangen, was die Steuerung 50 anhand der ihr zugeführten Qualitätssignale 27 und 37 feststellt, ist es erfindungsgemäß vorgesehen, dass das weitere oder die weiteren Empfangsteile 30, sowie die jeweils zugehörigen Vorfilter 31 soweit verstimmt werden, dass die an ihnen eingestellte oder eingestellten Empfangsfrequenz 62 oder Empfangsfrequenzen den vorgegebenen Mindestfrequenzabstand zu der mit nicht mehr mit ausreichender Empfangsqualität zu empfangenden ersten Rundfunkfrequenz 61 einhalten. Durch diese Verstimmung des weiteren Empfangsteils 32 oder der weiteren Empfangsteile wird erreicht, dass nur noch für den ersten Empfänger 20, an dem die gestörte Empfangsfrequenz 61 eingestellt ist, eine Impedanzanpassung im Bereich der betrachteten gestörten Empfangsfrequenz 61 vorliegt, so dass diese nunmehr ausschließlich durch den ersten Empfänger 20 aus dem Antennensignalsplitter 10 ausgekoppelt wird. Damit ergibt sich für diese erste Empfangsfrequenz 61 eine verringerte Dämpfung, da die Antennensignalleistung bei der betrachteten Empfangsfrequenz 61 für nur ein einziges, nämlich das erste Empfangsteil 22 zur Verfügung steht.

Somit besteht die Möglichkeit, dass die zuvor als nicht mehr ausreichend zu empfangende erste Rundfunkfrequenz 61 infolge einer erhöhten verfügbaren Empfangsignalleistung für das erste Empfangsteil 22 wieder mit ausreichender Empfangsqualität empfangen werden kann.

Vergleichbare Überlegungen gelten umgekehrt selbstverständlich auch für die zweite oder weitere Empfangsfrequenzen sinngemäß.

## Patentansprüche

1. Empfängeranordnung mit mindestens zwei Empfängern (20, 30), die über Antennensignalleitungen (25, 35) an eine gemeinsame Antenne (40) angeschlossen sind, wobei jeder der Empfänger (20, 30) über ein Vorfilter (21, 31) verfügt, welche Vorfilter (21, 31) eine Bandpasscharakteristik (71, 81) derart aufweisen, dass sie nur im Bereich ihrer Durchlassbandbreite (65, 66) eine Impedanzanpassung an die ihnen zugeführten Antennensignalleitungen (25, 35) aufweisen,
   **dadurch gekennzeichnet,**
   **dass** eine Steuerung (50) zur Erzeugung von Abstimmsteuersignalen (522, 532) zur Einstellung der beiden Empfänger (20, 30) auf jeweils eine Empfangrsfrequenz (61, 62) vorgesehen ist und dass die Steuerung (50) weiterhin zur Erzeugung von Vorfiltersteuersignalen (521, 531) zur Steuerung der Vorfilter (21, 31) derart ausgebildet ist, dass die Lage der Durchlassbandbreiten der Vorfilter (21,31) den an den jeweiligen Empfängern (20, 30) eingestellten Empfangsfrequenzen nach geführt wird.

2. Verfahren zur Steuerung von an eine gemeinsame Antenne (40) angeschlossenen Empfängern (20, 30), von denen jeder ein Vorfilter (21, 31) mit Bandpasscharakteristik aufweist,
   wobei die Empfangsfrequenzen der Empfänger (20, 30) auf zueinander verschiedene Empfangsfrequenzen (61, 62) eingestellt werden,
   **dadurch gekennzeichnet,**
   **dass** die Lagen der Durchlassbereiche (65, 66) der Vorfilter (21, 31) derart gesteuert werden, dass jede der eingestellten Empfangsfrequenzen (61, 62) jeweils im Durchlassbereich (65, 66) des dem auf die Empfangsfrequenz (61,62) abgestimmten Empfängers (20, 30) zugehörigen Vorfilters (21,31) liegt.

3. Verfahren nach Anspruch 2, **dadurch gekenn-**
   **zeichnet,**
   **dass** bei Verschlechterung der Empfangsqualität einer mittels eines ersten (20) der mindestens zwei Empfänger (20, 30) empfangenen Funkfrequenz (61) unter einen vorgegebenen Wert und für den Fall, dass die Empfangsfrequenz (62) des mindestens einen weiteren Empfängers (30) einen vorgegebenen Mindestfrequenzabstand zu der Empfangsfrequenz (61) des ersten Empfängers (20) nicht aufweist, die Empfangsfrequenz (62) des mindestens einen weiteren Empfängers (30) so eingestellt wird, dass sie zur Empfangsfrequenz (61) des ersten Empfängers (20) einen vorgegebenen Mindestfrequenzabstand (63) einhält.

4. Verfahren nach Anspruch 3, **dadurch gekennzeichnet, dass** der Mindestfrequenzabstand (63) durch die Bandbreite (65, 66) vorgegeben ist, innerhalb derer die Empfänger (20, 30) eine Eingangsimpedanzanpassung an die ihnen zugeführten Antennensignalleitungen (25, 35) aufweisen.

## Claims

1. Receiver arrangement having at least two receivers (20, 30) which are connected to a shared antenna (40) by means of antenna signal lines (25, 35), where each of the receivers (20, 30) has an input filter (21, 31), which input filters (21, 31) have a bandpass characteristic (71, 81) such that they have impedance matching to the antenna signal lines (25, 35) supplied to them only in the region of their passband (65, 66),
   **characterized**
   **in that** a controller (50) is provided for producing tuning control signals (522, 532) for setting the two receivers (20, 30) to a respective reception frequency (61, 62), and in that the controller (50) is also designed to produce input filter control signals (521, 531) for controlling the input filters (21, 31) such that the position of the passbands of the input filters (21, 31) is tracked to the reception frequencies which are set on the respective receivers (20, 30).

2. Method for controlling receivers (20, 30) which are connected to a shared antenna (40) and each of which has an input filter (21, 31) with a bandpass characteristic,
   where the reception frequencies of the receivers (20, 30) are set to reception frequencies (61, 62) which are different from one another,
   **characterized**
   **in that** the positions of the passbands (65, 66) of the input filters (21, 31) are controlled such that each of the set reception frequencies (61, 62) is respectively in the passband (65, 66) of the input filter (21, 31) associated with the receiver (20, 30) which is tuned to the reception frequency (61, 62).

**3.** Method according to Claim 2, **characterized in that** when the reception quality of a radio frequency (61) received by means of a first (20) of the at least two receivers (20, 30) is impaired below a prescribed value and if the reception frequency (62) of the at least one further receiver (30) is not at a prescribed minimum frequency interval from the reception frequency (61) of the first receiver (20), the reception frequency (62) of the at least one further receiver (30) is set such that it observes a prescribed minimum frequency interval (63) from the reception frequency (61) of the first receiver (20).

**4.** Method according to Claim 3, **characterized in that** the minimum frequency interval (63) is prescribed by the bandwidth (65, 66) within which the receivers (20, 30) have input impedance matching to the antenna signal lines (25, 35) which are supplied to them.

**Revendications**

**1.** Dispositif de récepteurs comprenant au moins deux récepteurs (20, 30) connectés à une antenne (40) commune par des lignes de signalisation (25, 35), chaque récepteur (20, 30) étant muni d'un premier filtre (21, 31) présentant une caractéristique de passe-bande (71, 81) telle qu'ils ne présentent une adaptation d'impédance aux lignes de signal d'antenne (25, 35) connectées à ceux-ci que dans la plage de leur largeur de bande passante (65, 66), **caractérisé en ce qu'** une commande (50) est prévue pour générer des signaux de syntonisation (522, 532) pour le réglage des deux récepteurs (20, 30) sur respectivement une fréquence de réception (61, 62), et la commande (50) est conçue en outre pour générer des signaux de commande de pré-filtrage (521, 531) pour commander les premiers filtres (21, 31) de sorte que la position des largeurs de bande passante des premiers filtres (21, 31) s'adapte aux fréquences de réception réglées sur les récepteurs (20, 30) respectifs.

**2.** Procédé de commande de récepteurs (20, 30) connectés à une antenne (40) commune, dont chacun présente un premier filtre (21, 31) avec une caractéristique de passe-bande, les fréquences de réception des récepteurs (20, 30) étant réglées sur des fréquences de réception (61, 62) différentes les unes des autres, **caractérisé en ce que** les positions des bandes passantes (65, 66) des premiers filtres (21, 31) sont commandées de sorte que chacune des fréquences de réception (61, 62) réglées se situe respectivement sur la bande passante (65, 66) du premier filtre (21, 31) associé au récepteur (20, 30) ajusté à la fréquence de réception (61, 62).

**3.** Procédé selon la revendication 2, **caractérisé en ce qu'** en cas d'une dégradation de la qualité de réception d'une fréquence radio (61) reçue au moyen d'un premier (20) des au moins deux récepteurs (20, 30) en dessous d'une valeur prédéterminée et au cas où la fréquence de réception (62) d'au moins un autre récepteur (30) ne présente pas un écart de fréquence minimum prédéterminé par rapport à la fréquence de réception (61) du premier récepteur (20), on règle la fréquence de réception (62) d'au moins un autre récepteur (30) de sorte à ce qu'elle respecte un écart de fréquence minimum (63) prédéterminé par rapport à la fréquence de réception (61) du premier récepteur (20).

**4.** Procédé selon la revendication 3, **caractérisé en ce que** l'écart de fréquence minimum (63) est prédéterminé par la largeur de bande (65, 66) sur laquelle les récepteurs (20, 30) présentent une adaptation de l'impédance d'entrée aux lignes de signal d'antenne (25, 35) auxquelles ils sont connectés.

Fig. 1

Fig. 2

Fig. 3